# EUROPEAN PATENT APPLICATION

(11) **EP 1 988 186 A1**
(43) Date of publication of application: **05.11.2008**
(21) Application number: 07425244.6
(22) Date of filing: 24.04.2007
(51) Int. Cl.: C23C 14/56

(54) **Multichamber vacuum deposition system**

(71) Applicant: Galileo Vacuum Systems S.p.A., 59100 Prato (IT)
(72) Inventor: Pagani, Angelo, 40138 Bologna (IT)
(74) Representative: Mannucci, Michele

(57) **Abstract**

The vacuum deposition system comprises in combination:
- a vacuum unwinding chamber (1), in which an unwinder is arranged, to unwind a reel (B1) of web material (N) to be treated;
- at least a first vacuum treatment chamber (13), in which at least a first process roller (17), around which the web material is fed, and a first vacuum evaporation source (45) are arranged;
- a vacuum rewinding chamber (101), in which a winder is arranged, to wind the treated web material on a reel (B2);
- a path for the web material that extends from the vacuum unwinding chamber to the vacuum winding chamber, passing through said at least one first vacuum treatment chamber.

## Description

### Technical Field

The present invention relates to a vacuum deposition system and more specifically to a system for vacuum deposition of a layer of coating on a continuous substrate or medium, substantially in the form of a web, such as a plastic film, a sheet of paper or the like.

### State of the art

Vacuum deposition is a technique used in many industrial fields to produce articles on which a coating layer is formed, such as a metal layer (metallization systems), a layer with a barrier effect, for example to produce packaging film or similar and the like.

In some systems the articles to be treated are loaded in batches into the metallization or vacuum deposition chamber.

For vacuum deposition of coating layers, metallization layers or the like on a continuous substrate or medium, such as a film or the like, systems or plants are used comprising a metallization chamber, which can be divided into two portions, with a system for unwinding a reel or substrate to be processed and a winder to wind a reel of substrate or medium after the coating layer has been formed thereon. Between the unwinder and the winder there extends a substrate feed path, along which a process roller is provided. The web substrate is fed around the process roller so that the surface thereof facing the outside, i.e. not in contact with the process roller, can receive the material vaporized from one or more vaporization sources disposed under the process roller.

Vacuum deposition systems of this type, also called roll-to-roll or reel-to-reel systems, are described for example in EP-A-1,693,481; EP-A-1,440,178; EP-A-0,656,430.

The vaporization sources contain one or more substances that are vaporized or sublimed by means of power, for example by heating or with an electron gun or the like. In some systems the sources are heated by electrical induction or Joule effect.

The vacuum chambers of these systems normally extend approximately cylindrically or prismatically, with a substantially horizontal axis and have limited dimensions so that it is not possible to unwind and wind reels of web material beyond a certain dimension. Moreover, again due to the dimensional limits of these chambers, it is not possible to increase as at will the dimension of the process roller or to place more than one process roller inside the same chamber. Therefore, it is not always possible to position the desired number of vaporization sources or other processing stations along the feed path of the web material.

### Objects and summary of the invention

According to one aspect, an object of the invention is to provide a vacuum deposition system, in particular for web materials, i.e. continuous substrates, such as plastic films, paper or the like, which overcomes entirely or in part the limits of conventional systems.

An object of a preferred embodiment of the invention is to propose a vacuum deposition system for web materials, i.e. continuous substrates, in which it is possible to perform a high number of processes and/or to treat both surfaces of the substrate.

In substance, according to an embodiment, the invention provides for a vacuum deposition system, comprising in combination: a vacuum unwinding chamber, in which an unwinder is arranged, to unwind a reel of web material to be treated; a first vacuum treatment chamber, in which there are arranged at least a first process roller, around which the web material is fed, and a first vacuum evaporation source; preferably a second vacuum treatment chamber, in series with the first vacuum treatment chamber, in which there are arranged at least a second process roller, around which the web material is fed, and a second vacuum evaporation source; a vacuum winding chamber, in which a winder is arranged, to wind the treated web material on a reel; a vacuum path for the web material extending from the vacuum unwinding chamber to the vacuum winding chamber, passing through the interposed vacuum treatment chamber or chambers.

With an arrangement of three chambers in series it is possible to process reels of web material of large dimensions and considerable weight, without problems of overall dimensions and mechanical vibrations in the vacuum deposition area. Moreover, by having two vacuum deposition chambers, i.e. a first and a second vacuum treatment or process chamber, disposed between an unwinding chamber and a winding chamber, different processes can be carried out on the web material in sequence.

Advantageously, between adjacent vacuum chambers the path of the substrate extends along sealed vacuum passages, in which one or more treatment stations, for example plasma or other treatment systems, can advantageously be arranged.

According to an improved embodiment of the invention, in the second vacuum treatment or process chamber there are disposed guide members of the web material which define a path of the web material so that in said vacuum chamber the web material is in contact with the second process roller with the surface treated in the previous vacuum process or treatment chamber, to allow treatment of the two opposite surfaces of the web material in the two vacuum chambers disposed in sequence.

In a preferred embodiment, in the second vacuum treatment chamber there can be defined two alternative paths for the web material, to treat one or other of the two surfaces of the web material alternatively around the second process roller.

Further advantageous characteristics and embodiments of the invention are indicated in the appended dependent claims and will be described in greater detail hereunder with reference to a possible embodiment of the invention.

### Brief description of the drawings

The invention will be better understood by following the description and accompanying drawing, which shows a non-limiting practical embodiment of the invention. More specifically, in the drawing:

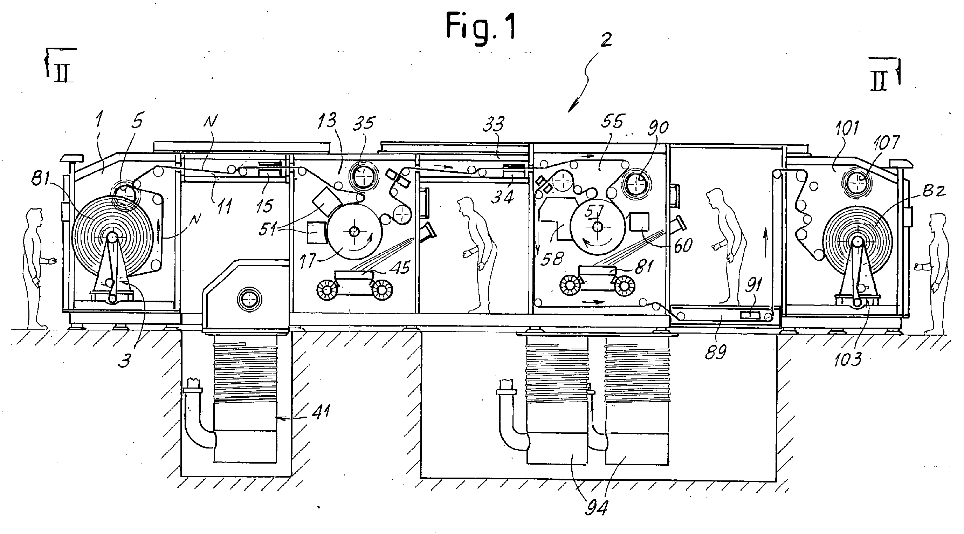

Figure 1 shows a section according to a longitudinal vertical plane of a system according to the invention;
Figure 2 shows a plan view according to II-II in Figure 1; and

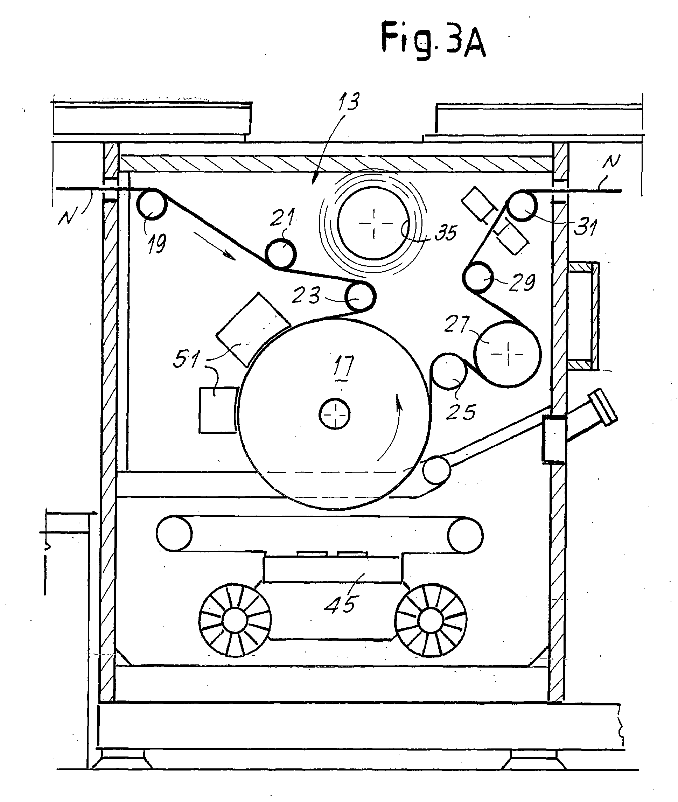

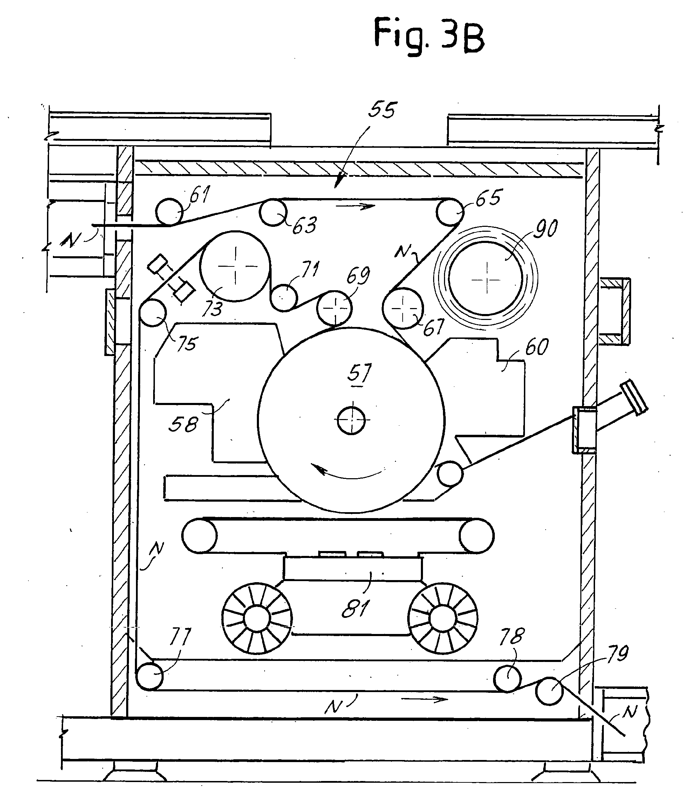

Figures 3A and 3B show enlargements of the two deposition chambers of the system in Figure 1.

### Detailed description of an embodiment of the invention

Hereunder reference will be made to a system with four vacuum chambers, which will be denominated as follows:
- the vacuum unwinding chamber is indicated as the first vacuum chamber;
- the first and second vacuum treatment or process chamber are indicated as the second and the third vacuum chamber;
- the vacuum winding chamber is indicated as the fourth vacuum chamber.

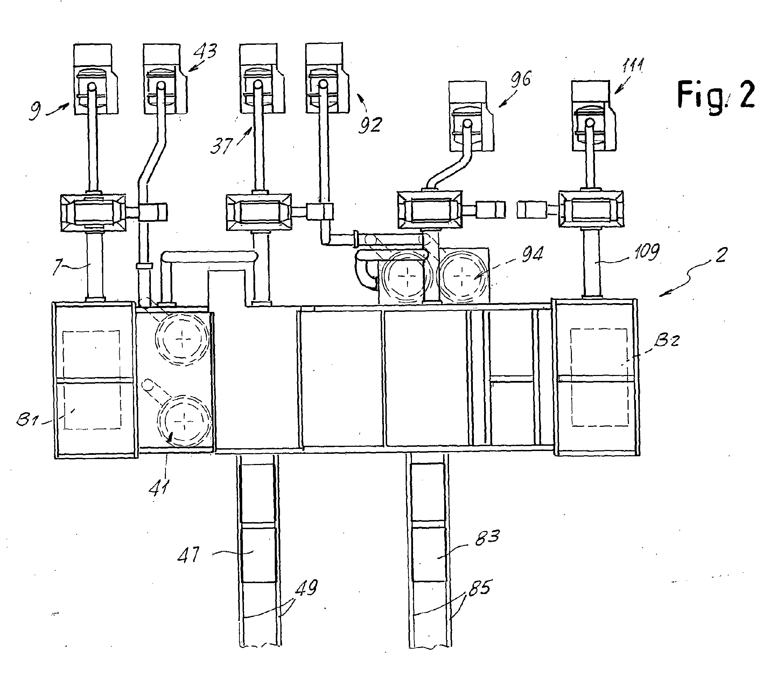

In the embodiment shown the system, indicated as a whole with 2, comprises a first vacuum chamber 1, or unwinding chamber, in which there are disposed reels B1 of film or other continuous web substrate on which one or more vacuum deposition treatments and/or other surface treatments must be performed. Inside the first vacuum chamber there is disposed an unwinding system or unwinder, indicated as a whole with 3 to unwind the web material N from the reel B1. Through a connection 5 the first vacuum chamber 1 is connected to a suction duct 7 (Figure 2), by means of which a pumping unit 9 generates and maintains inside the first chamber 1 a suitable degree of vacuum. The pumping unit 9 can comprise mechanical pumps, such as rotary pumps. In an embodiment of the invention, the pumping unit 9 comprises an arrangement of rotary pumps and Roots pumps in series. In general, the degree of vacuum required in the unwinding chamber 1 is not particularly high and therefore it is not necessary to provide diffusion pumps in series with the mechanical rotary pumps and/or Roots pumps, although a configuration of this type would also be possible.

The first vacuum chamber 1 is connected to a sealed vacuum passage 11 which connects the first vacuum chamber 1 to a second vacuum chamber 13 (first process or treatment chamber), which constitutes one of the vacuum deposition chambers of the system. The passage 11 is in fluid connection with the chamber 1 and with the vacuum chamber 13 and is therefore maintained under vacuum and the web material N passes therethrough. The passage 11 can also be connected to a pumping unit by means of a direct connection thereof.

In an embodiment in the passage 11 a treatment station or unit 15 is arranged. In an embodiment the station 15 can be a plasma treatment device of the web material N which passes through the passage 11. In a different embodiment in the passage 11 several treatment stations can be arranged, for example also stations for treating both opposite surfaces of the web substrate N.

In the second vacuum chamber 13 a first process roller 17 is arranged, around which the path of the web material N extends. In an embodiment the path of the web material inside the second vacuum chamber 13 is defined, as well as by the process roller 17, by an assembly of rollers 19, 21, 23, 25, 27. In an embodiment the roller 21 is a spreading roller. In a possible embodiment the roller 27 is a cooled capstan roller on which the web material treated around the process roller 17 is suitably cooled. Downstream of the roller 27 are provided further rollers 29, 31 which define the path of the web material N towards the inlet of a second passage 33.

The second vacuum chamber 13 is connected by means of a union 35 to a pumping system comprising a pumping unit 37, for example comprising an arrangement of rotary and Roots pumps in series, similar to those provided for the pumping unit 9, which generates and maintains the vacuum in the chamber 1. In an embodiment one or more diffusion pumps 41 connected in series to a further pumping unit 43 are associated with the second vacuum chamber 13. Just as the units 9 and 37, the second pumping unit 43 can include rotary and Roots pumps in series in a manner known per se.

In the example shown, the pumping unit 37 is also connected to the body of the diffusion valve.

Under the process roller 17, in the vacuum chamber 13 are arranged vacuum deposition sources indicated as a whole with 45, of a type known per se and not described in greater detail herein. The nature of the sources and the material that is inserted or fed thereto can vary according to the type of substrate to be treated, to the nature of the deposit to be formed thereon, to the final use of the product and so forth.

In an embodiment the sources 45 are mounted on an extractable carriage, indicated schematically with 47 (Figure 2), which can be extracted from the vacuum chamber 13 along tracks 49 to allow maintenance, cleaning, replacement of worn materials and/or other secondary operations.

In an embodiment, around the extension of the process roller 17 there can be disposed one or more further treatment stations, indicated as a whole with 51. These stations can for example be stations for applying an oil or other liquid material which -suitably distributed on the web material N, for example according to a specific pattern - prevents metallization on predetermined areas thereof. This technique is used, for example, to produce a web material that has discontinuous metallization, with metal-free patterns and/or areas disposed according to longitudinal strips or in any other desired manner.

Downstream of the arrangement of sources 45 there can be disposed one or more treatment stations (not shown) similar to what is shown upstream of the process roller 17, for example nozzles for acrylate, with UV cross-linking or electron gun devices.

The second vacuum chamber 13 is connected, through the path or passage 33, to a third vacuum chamber 55 (second vacuum process or treatment chamber). Inside the path 33 a suitable degree of vacuum is maintained through an autonomous pumping system or through the pumping system connected to the chambers 13 or 55 respectively. In an embodiment, in the third vacuum chamber 55 there is disposed a second process roller 57 analogous or similar to the first process roller 17 provided in the vacuum chamber 13.

Along the passage 33 one or more treatment stations can be arranged, for example a plasma treatment station 34 or another type of station.

Inside the vacuum chamber 55 guide rollers for the web material N are arranged, which define one or more alternative paths of the web material inside the third vacuum chamber 55.

In an embodiment, the guide rollers disposed inside the vacuum chamber 55 can be produced so as to define two alternative paths of the web material around the process roller 57. Advantageously, the two alternative paths are such that if the web material is guided along one of said paths it is in contact with the process roller 57 with the same surface that in the second vacuum chamber 13 is in contact with the process roller 17. In this case in the two vacuum chambers 13 and 55 the web material N is treated on the same surface, i.e. the one that in both chambers is facing outwards with respect to the process rollers 17 and 57. The second alternative path of the film or other substrate or web material N inside the vacuum chamber 55 is designed so that therealong the web material is in contact with the process roller 57 with the surface that was treated in the previous vacuum chamber 13, i.e. the surface that in the vacuum chamber 13 was facing towards the vaporization sources 55.

In an embodiment, inside the vacuum chamber 55 these two alternative paths are defined by rollers 61, 63, 65, 67, 69, 71, 73, 75, 77, 78 and 79.

In an embodiment, one or more of the rollers 61-79 are spreading rollers. For example, the roller 67 can be a spreading roller. Advantageously, one or more of the aforesaid rollers can be cooled rollers or capstan rollers. For example, the roller 73 can be a cooled roller. There can also be provided several spreading rollers and several capstan rollers or cooled rollers so that in any case there is a spreading roller upstream of the contact area of the web material N with the process roller 57 and a cooled roller downstream of the contact area between the web material N and the second process roller 57, irrespective of the path taken by the web material or substrate N.

Under the second process roller 57 there are arranged vaporization sources 81, also preferably disposed on a carriage 83 which can be extracted transversely from the vacuum chamber 55. As for the carriage 47, the carriage 83 is also movable on rails 85 preferably disposed on the same side of the system 1 on which there are disposed the rails 49 for extraction of the carriage 47 of the vacuum chamber 13. The vaporization sources 81 can be the same or different with respect to the sources 45 of the vacuum chamber 13.

Around the second process roller 57 further stations or work units indicated with 58 and 60 can be provided, for example similar to the treatment stations 51 described with reference to the chamber 13.

The third vacuum chamber 55 is connected by means of a union 90 to a pumping unit 92 which can comprise, for example, rotary pumps and Roots pumps in series. Advantageously; in the example shown, in order to maintain a suitable degree of vacuum in the third vacuum chamber 55 the pumping system also comprises a pair of diffusion pumps 94. As in the case of the second vacuum chamber 13, the diffusion pumps allow a degree of vacuum to be maintained inside the vacuum chamber 55 which is higher than the one obtained only by the rotary pumps and Roots pumps.

In an embodiment, the vacuum chamber 55 is connected to a vacuum passage 89, through which there extends the path of the web material N and along which there can be provided, for example, one or more secondary treatment stations, for example a plasma treatment station 91. A pumping unit 96, for example comprising Roots pumps and rotary pumps in series, can be connected to the vacuum passage 89.

The passage 89 is connected to a fourth vacuum chamber 101 (winding chamber), inside which the web material treated in the previous vacuum chambers 13 and 55 is wound to form a reel B2. The number 103 indicates a winding system of the reel B2. In an embodiment the fourth vacuum chamber 101 is in fluid connection by means of a union 107 with a duct 109, which is in turn connected to a pumping unit 111 which comprises, analogous to the pumping unit 9, for example Roots pumps and rotary pumps to maintain a lower degree of vacuum in the vacuum winding chamber 101 than the vacuum in the chambers 13 and 55.

It is understood that the drawing only shows an example given by way of a practical embodiment of the invention, and that said invention can vary in forms and arrangements without however departing from the scope of the concept underlying the invention. Any reference numbers in the appended claims are provided to facilitate reading of the claims with reference to the description and to the drawing, and do not limit the scope of protection represented by the claims.

## Claims

1. A vacuum deposition system, comprising in combination:
- a vacuum unwinding chamber, in which an unwinder is arranged, to unwind a reel of web material to be treated;
- at least a first vacuum treatment chamber, in which at least a first process roller, around which the web material is fed, and a first vacuum evaporation source are arranged;
- a vacuum rewinding chamber, in which a winder is arranged, to wind the treated web material on a reel;
- a path for the web material that extends from the vacuum unwinding chamber to the vacuum winding chamber, passing through said at least one first vacuum treatment chamber.

2. System as claimed in claim 1, comprising a second vacuum treatment chamber disposed between the first vacuum treatment chamber and the winding chamber, in the second vacuum treatment chamber at least a second process roller, around which the web material is fed, and a second vacuum evaporation source being arranged.

3. System as claimed in claim 1 or 2, wherein between adjacent vacuum chambers said path extends along sealed vacuum passages.

4. System as claimed in claim 3, wherein in at least one of said sealed passages between adjacent chambers at least one treatment station for the web material is arranged.

5. System as claimed in claim 4, wherein said at least one treatment station is a plasma treatment station.

6. System as claimed in claim 4, wherein said at least one station is an acrylate application unit.

7. System as claimed in one or more of the previous claims, wherein in the second vacuum treatment chamber guide members for the web material are arranged, which define a path of the web material so that in the second vacuum treatment chamber the web material is in contact with the second process roller with the surface treated in the first vacuum treatment chamber, to allow treatment of the two opposite surfaces of the web material in the first and second vacuum treatment chambers.

8. System as claimed in claim 7, wherein in said second vacuum treatment chamber two alternative paths for the web material are defined, to treat around said second process roller alternatively one or other of the two surfaces of the web material.

9. System as claimed in one or more of the previous claims, comprising distinct pumping units for at least some of said vacuum chambers.

10. System as claimed in one or more of the previous claims, comprising separate pumping units for each of said vacuum chambers.

11. System as claimed in one or more of the previous claims, wherein with said first and with said optional second vacuum treatment chamber are associated pumping units which reach a higher degree of vacuum with respect to the degree of vacuum in the vacuum unwinding chamber and in the vacuum winding chamber.

12. System as claimed in one or more of the previous claims, wherein in said first and second vacuum treatment chamber extractable carriages which support the evaporation sources are disposed.

## Amended claims

### Amended claims in accordance with Rule 137(2) EPC.

**1.** A vacuum deposition system, comprising in combination:
- a vacuum unwinding chamber, in which an unwinder is arranged, to unwind a reel of web material to be treated;
- at least a first vacuum treatment chamber, in which at least a first process roller, around which the web material is fed, and a first vacuum evaporation source are arranged;
- at least a second vacuum treatment chamber, in which at least a second process roller, around which the web material is fed, and a second vacuum evaporation source are arranged;
- a vacuum rewinding chamber, in which a winder is arranged, to wind the treated web material on a reel;
- a path for the web material that extends from the vacuum unwinding chamber to the vacuum winding chamber, passing through said at least one first vacuum treatment chamber;
**characterized in that** in the second vacuum treatment chamber guide members for the web material are arranged, which define a path of the web material such that in said second vacuum treatment chamber the web material is in contact with the second process roller with the surface treated in the first vacuum treatment chamber, to allow treatment of the two opposite surfaces of the web material in the first and second vacuum treatment chambers.

**2.** System as claimed in claim 1, wherein said second vacuum treatment chamber is arranged between the first vacuum treatment chamber and the winding chamber.

**3.** System as claimed in claim 1 or 2, wherein in said second vacuum treatment chamber web-guiding members are arranged, which define two alternative paths for the web material, to treat around said second process roller alternatively one or other of the two surfaces of the web material.

**4.** System as claimed in claim 1 or 2 or 3, wherein between adjacent vacuum chambers said path extends along sealed vacuum passages.

**5.** System as claimed in claim 4, wherein in at least one of said sealed passages between adjacent chambers at least one treatment station for the web material is arranged.

**6.** System as claimed in claim 5, wherein said at least one treatment station is a plasma treatment station.

**7.** System as claimed in claim 6, wherein said at least one station is an acrylate application unit.

**8.** System as claimed in one or more of the previous claims, wherein around the extension of at least one of said process roller one or more further treatment stations are arranged, selected from the group including: stations for applying a liquid preventing metallization on predetermined areas of said web material; acrylate spraying nozzles; UV cross-linking devices; electron gun devices.

**9.** System as claimed in one or more of the previous claims, comprising distinct pumping units for at least some of said vacuum chambers.

**10.** System as claimed in one or more of the previous claims, comprising separate pumping units for each of said vacuum chambers.

**11.** System as claimed in one or more of the previous claims, wherein with said first and with said optional second vacuum treatment chamber are associated pumping units which reach a higher degree of vacuum with respect to the degree of vacuum in the vacuum unwinding chamber and in the vacuum winding chamber.

**12.** System as claimed in one or more of the previous claims, wherein in said first and second vacuum treatment chamber extractable carriages which support the evaporation sources are disposed.
